**Europäisches Patentamt**

**European Patent Office**

**Office européen des brevets**

(19)

(11) Veröffentlichungsnummer: **0 037 988**
**B1**

(12) **EUROPÄISCHE PATENTSCHRIFT**

(45) Veröffentlichungstag der Patentschrift:
18.07.84

(51) Int. Cl.³: **H 05 K 3/10**

(21) Anmeldenummer: **81102525.3**

(22) Anmeldetag: **03.04.81**

(54) **Verfahren zur Aufbringung von elektrisch leitenden Bahnen auf einen Träger aus Isolierstoff.**

(30) Priorität: **11.04.80 DE 3014041**

(43) Veröffentlichungstag der Anmeldung:
**21.10.81 Patentblatt 81/42**

(45) Bekanntmachung des Hinweises auf die Patenterteilung:
**18.07.84 Patentblatt 84/29**

(84) Benannte Vertragsstaaten:
**AT BE CH FR GB IT LI LU NL SE**

(56) Entgegenhaltungen:
**DE - A - 1 915 756**
**DE - A - 2 336 917**
**DE - A - 2 854 385**
**DE - B - 1 098 560**
**DE - B - 1 440 866**
**DE - B - 2 007 818**
**GB - A - 1 248 601**

(73) Patentinhaber: **Braun Aktiengesellschaft,**
**Rüsselsheimer Strasse 22, D-6000 Frankfurt/Main (DE)**

(72) Erfinder: **Schweingruber, Otto, Höhenblick 1,**
**D-6246 Glashütten (DE)**
Erfinder: **Häfner, Werner, Lärchenweg 20,**
**D-6967 Buchen-Hainstadt (DE)**

(74) Vertreter: **Einsele, Rolf, Braun Aktiengesellschaft**
**Postfach 1120 Frankfurter Strasse 145, D-6242 Kronberg**
**Taunus (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren zur Aufbringung von elektrisch leitenden Bahnen auf einen Träger aus Isolierstoff.

Der Träger kann als ebene Platte oder auch als Körper mit Ebenen in verschiedener Höhe oder mit winklig zueinander stehenden Ebenen ausgebildet sein.

Anwendung finden solche Träger mit Leiterbahnen für elektrischen Strom vor allem in elektrischen und elektronischen Kleingeräten.

Durch die DE-AS 10 98 560 ist bereits ein Verfahren zum Aufbringen von elektrisch leitenden Bahnen auf einen Träger aus Isolierstoff bekannt, bei dem der Träger mit Kanälen im Muster der Leiterbahnen versehen wird, diese Kanäle mit einem elektrisch leitfähigen Material gefüllt werden und dieses Material galvanisch verstärkt wird. Das Versehen des Trägers mit Kanälen gemusterter Leiterbahnen ist schwierig und aufwendig.

Aus der DE-OS 23 36 917 ist es bekannt, Träger aus Isolierstoff im Spritzgußverfahren herzustellen und den gesamten Träger zu metallisieren; gemusterte Leiterbahnen werden aber nicht ausgebildet.

Aus dem DE-GM 19 66 250 ist eine Anordnung nach Art einer elektrischen Schaltungsplatte bekannt, bei der auf einen Träger aus Isolierstoff Metallschichten als Strombahnen aufgebracht sind, wobei der Träger ein dreidimensionaler Körper aus einem an sich bekannten Kunststoff aus der Gattung der ABS-Polymere, insbesondere einem ABS-Pfropfpolymerisat, ist, auf den die Strombahnen galvanisch aufgebracht sind.

Zur Herstellung der Leiterbahnen war dem Fachmann bekannt (Rempel, Sonderdruck »Neue Beobachtungen bei der chemogalvanischen Metallisierung von Formkörpern aus ABS-Polymerisaten« aus »Fachberichte für Oberflächentechnik«, 1970) durch Ätzung, insbesondere mit Chromschwefelsäure, den Butadienanteil anzugreifen, mit einem Lack in dem gewünschten Muster abzudecken, autokatalytisch eine sehr dünne Metallschicht abzuscheiden und dann auf dieser galvanisch die die Strombahn bildenden Metallschicht aufzubringen.

Dieses Verfahren ist, wie man Rempel l. c. entnehmen kann, mit einer Reihe von Schwierigkeiten verbunden und durch die Verwendung von Chromschwefelsäure bei dem Ätzen umweltbelastend. Trotz hohem Aufwand in der Fertigung war es nicht möglich, körperlich ausgebildete Platten mit Leiterbahnen für elektrischen Strom reproduzierbar in großen Stückzahlen herzustellen.

Die Erfindung hat die Aufgabe, ein Verfahren zur Aufbringung von elektrisch leitenden Bahnen auf einen Träger aus Isolierstoff zur Verfügung zu stellen, welches die Aufbringung der Leiterbahnen in dem jeweils gewünschten Muster reproduzierbar in großen Stückzahlen in wirtschaftlicher Weise ermöglicht.

Die Erfindung löst die Aufgabe durch ein Verfahren zum Aufbringen von elektrischen Leitern auf einen Träger aus Isolierstoff, bei dem der Träger durch Spritzgießen mit Kanälen gemusterter Leiterbahnen versehen wird, diese Kanäle mit einem elektrisch leitfähigen Kunststoff gefüllt werden und dieses Material sodann galvanisch verstärkt wird, dadurch gekennzeichnet, daß die Kanäle derart mit dem elektrisch leitfähigen Kunststoff befüllt werden, daß zwischen den Seiten des elektrisch leitfähigen Kunststoffs und den Wänden der Kanäle Rollen gebildet werden.

Man erhält einen Träger aus Isolierstoff mit Leiterbahnen für elektrischen Strom in der jeweiligen gewünschten Ausbildung in reproduzierbarer Weise wirtschaftlich in großen Stückzahlen.

Als Träger aus Isolierstoff werden handelsübliche elektrisch nicht leitfähige, durch Spritzgießen formbare Kunststoffe verwendet. Als elektrisch leitfähiger Kunststoff werden handelsübliche durch Spritzen formbare elektrisch leitfähige Kunststoffe verwendet.

Das Spritzgießen und Spritzen wird mit an sich bekannten Maschinen und Werkzeugen in an sich bekannter Weise vorgenommen.

Die galvanische Verstärkung erfolgt in an sich bekannter Weise.

Die Kanäle dienen als Führung für die Form zum Einspritzen des elektrisch leitfähigen Kunststoffes. Durch die Wände der Form wird eine volle Befüllung der Kanäle verhindert und damit erzielt, daß der Träger aus Isolierstoff von dem elektrisch leitfähigen Kunststoff an dessen Seitenwänden durch Rillen getrennt wird. Bei der galvanischen Verstärkung wird das elektrisch leitende Metall in die Rillen mit abgeschieden; dadurch wird eine bessere Verankerung der galvanischen Verstärkung bewirkt.

Ein Vorteil des erfindungsgemäßen Verfahrens ist es auch, daß man eine Bestückung vor der galvanischen Verstärkung anbringen kann und durch diese Verstärkung die Bestückung derart fest verbunden wird, daß man sich ein Anlöten ersparen kann.

Ein weiterer Vorteil des erfindungsgemäßen Verfahrens ist, daß man auch auf den Innenteil von Hohlkörpern, z. B. Gehäusen, Leiterbahnen für elektrischen Strom aufbringen kann.

## Patentanspruch

Verfahren zum Aufbringen von elektrischen Leitern auf einem Träger aus Isolierstoff, bei dem der Träger durch Spritzgießen mit Kanälen gemusterter Leiterbahnen versehen wird, diese Kanäle mit einem elektrisch leitfähigen Kunststoff gefüllt werden und dieses Material sodann galvanisch verstärkt wird, dadurch gekennzeichnet, daß die Kanäle derart mit dem elektrisch leitfähigen Kunststoff befüllt werden, daß zwischen den Seiten des elektrisch leitfähigen Kunststoffs und den Wänden der Kanäle Rillen gebildet werden.

## Claim

Process for applying electrical conductors to an insulating material support, in which the support is provided by injection moulding with printed conductors patterned by ducts, said ducts being filled with an electrically conductive plastic and said material is then galvanically strengthened, characterized in that the ducts are filled with the electrically conductive plastic in such a way that between the sides of the electrically conductive plastic and the walls of the ducts grooves are formed.

## Revendication

Procédé pour appliquer des conducteurs électriques sur un support en matériau isolant, selon lequel on dote le support par moulage pour injection de canaux de matière plastique électriquement conductible puis on renforce cette matière par galvanoplastie, qui est caractérisé en ce que l'on remplit les canaux de matière électriquement conductible de manière que des rainures se forment entre les côtés de la matière plastique électriquement conductible et les parois des canaux.